# EUROPEAN PATENT APPLICATION

(11) **EP 4 685 838 A2**
(43) Date of publication of application: **28.01.2026**
(21) Application number: 25184821.4
(22) Date of filing: 24.06.2025
(51) Int. Cl.: H01J 37/317, H01J 37/20, H01J 37/02

(54) **LITHOGRAPHY SYSTEM**

(30) Priority: 25.06.2024 JP 2024102193; 29.11.2024 EP 24216413
(71) Applicant: IMS Nanofabrication GmbH, 2345 Brunn am Gebirge (AT); JEOL Ltd., Akishima, Tokyo 196-8558 (JP)
(72) Inventor: KOBAYASHI, Noriyuki, Tokyo, 196-8558 (JP); TAKIZAWA, Yoshiaki, Tokyo, 196-8558 (JP); OKANO, Hideto, Tokyo, 196-8558 (JP); PLATZGUMMER, Elmar, 1090 Vienna (AT)
(74) Representative: Patentanwaltskanzlei Matschnig & Forsthuber OG

(57) **Abstract**

A lithography system for drawing patterns on a substrate (2) by irradiating the substrate with a beam of charged particles includes a stage for supporting the substrate, at least one conduction pin (16, 26) for connecting the substrate to a reference potential, and at least one actuator (12, 22) for moving the respective conduction pin. The at least one actuator (12, 22) is configured to move the respective conduction pin (16, 26) between a position where it contacts the substrate and a position where it does not contact the substrate. A resistance measurement circuit can measure the resistance between the first and second conduction pins, and if the resistance value is not less than a threshold value, the actuators are operated so as to lower the resistance value below the threshold value.

## Description

### Technical Field

The present invention relates to a lithography system for drawing patterns on a material (substrate) by irradiating the material with a beam of charged particles.

### Background of the Invention

A lithography system uses a charged particle beam, such as an electron beam, to draw fine patterns, such as semiconductor integrated circuit patterns, on materials such as mask blanks and semiconductor substrates.

In such a lithography system, the material is connected to a reference potential to prevent charging of the material due to irradiation of the charged particle beam. The reference potential may be a ground level (0 V) or a specific potential.

For example, JP 561-151332 discloses a lithography system with a needle that breaks through the resist on the topmost surface of the mask blank and connects the conductive film under the resist to ground. The force to push the needle against the resist is provided by a spring.

### Problem Underlying the Invention

There are various types of mask blanks and various resist film thicknesses. In lithography devices such as the one disclosed in JP S61-151332, the force to push the needle against the resist is constant. Therefore, for example, when the resist is thick, the needle may not be able to penetrate the resist and may not be able to connect to ground. Also, if the resist is thin, the needle may severely damage the surface of the mask blanks, resulting in a lot of dust.

### Summary of Invention

The invention is directed at a lithography system comprising one or more conduction pins as defined in independent claim 1. Further optional features of the invention are described in the dependent claims.

One aspect of the lithography system for the present invention is a lithography system for drawing patterns on a material (substrate) by irradiating the material with a beam of charged particles, including a stage for supporting the material, a first conduction pin for connecting the material to a reference potential, and a first actuator for moving the first conduction pin.
In such a lithography system, the first actuator can move the first conduction pin, which allows the force of pressing the first conduction pin against the material to be variable.

### Brief Description of the Drawings

The drawings show in schematic depictions:
- Fig. 1:: overview of the configuration of the lithography system according to a first embodiment.
- Fig. 2:: plan view of the stage.
- Fig. 3:: diagram of the first contact section.
- Fig. 4:: diagram of the first and second contact sections.
- Fig. 5:: diagram illustrating the operation of the first contact section.
- Fig. 6:: diagram illustrating the operation of the first contact section.
- Fig. 7:: diagram illustrating the operation of the first contact section.
- Fig. 8:: diagram illustrating the function of elastic members.
- Fig. 9:: diagram of a variant of the first contact section.
- Fig. 10:: diagram of a variant of the first and second contact sections.
- Fig. 11:: diagram of another variant of the first and second contact sections.
- Fig. 12:: diagram showing the configuration of the lithography system according to a second embodiment.
- Fig. 13:: flowchart showing an exemplary process for connecting a material to a reference potential.
- Fig. 14:: diagram showing the configuration of the lithography system according to a third embodiment.
- Fig. 15:: flowchart showing an exemplary process for connecting a material to a reference potential.
- Fig. 16:: diagram showing the configuration of the lithography system according to a fourth embodiment.
- Fig. 17:: diagram of the first and second contact sections.
- Fig. 18:: diagram of the second and third contact sections.
- Fig. 19:: diagram of the third and first contact sections.
- Fig. 20:: flowchart showing an exemplary process for connecting a material to a reference potential.
- Fig. 21:: diagram of the first contact section of the lithography system according to a fifth embodiment.
- Fig. 22:: Diagram illustrating the operation of the first contact section.
- Fig. 23:: Diagram illustrating the operation of the first contact section.

### Detailed Description of Embodiments

Suitable embodiments of the invention will be described in detail below with reference to the drawings. The embodiments described in the following are for illustrating purposes and are not limiting to the invention as described in the claims. Also, the embodiments shown may contain elements which are not essential to the invention.

### 1. 1st embodiment

### 1.1. lithography System.

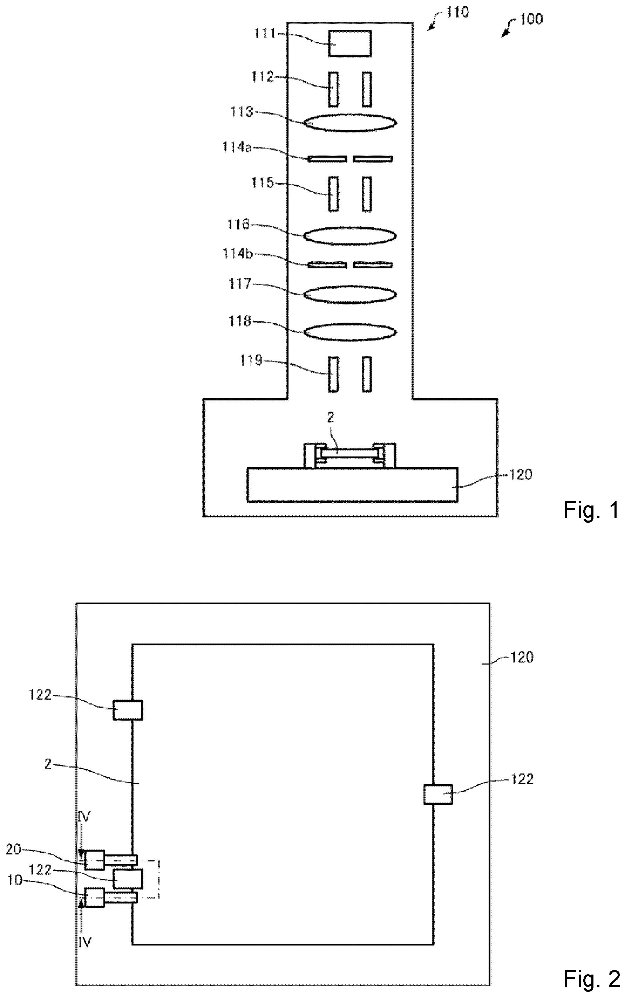

First, the lithography system according to a first embodiment will be described with reference to the drawings. Fig. 1 shows the configuration of the lithography system 100 for one embodiment.

The lithography device 100 is a device that irradiates an electron beam onto the material 2 to draw a pattern on the material 2. The lithography device 100, for example, draws a fine pattern, such as a semiconductor integrated circuit pattern, on the material 2. Here, the material 2 is, for example, a semiconductor substrate, a mask blank, etc.; a mask blanks is a material for photomasks.

Referring to Fig. 1, the lithography system 100 includes an electron optical system 110 and a stage 120.

The electron optics 110 includes an electron gun 111, a blanker 112, an irradiation lens 113, a first slit 114a, a forming deflector 115, a forming lens 116, a second slit 114 b, a reducing lens 117, an objective lens 118, and a positioning deflector 119. The electro-optics 110 is housed in a lens barrel maintained in a vacuum.

The electron gun 111 generates an electron beam. The blanker 112 deflects the electron beam emitted from the electron gun 111 and adjusts the time during which the electron beam passes through the first slit 114a. In other words, the amount of electron beam irradiated to the material 2 can be adjusted by the blanker 112. Once the electron beam has passed through the blanker 112, it is irradiated to the first slit 114a through the irradiation lens 113.

The first slit 114a, forming deflector 115, forming lens 116, and second slit 114b shape the electron beam. The image formed by the electron beam passing through the first slit 114a is formed on the second slit 114b by the forming lens 116. By deflecting the electron beam with the forming deflector 115, the position of the image formed by the first slit 114 a on the second slit 114b can be changed. This allows the electron beam to be shaped. By controlling the deflection direction and deflection amount of the electron beam in the forming deflector 115, the electron beam can be formed into any desired shape.

The reduction lens 117 reduces the image formed by the first slit 114a, the forming deflector 115, the forming lens 116, and the second slit 114b. The objective lens 118 forms the image reduced by reduction lens 117 on the material 2. The positioning deflector 119 deflects the electron beam that has passed through the objective lens 118. This allows the irradiation position of the electron beam to the material 2 to be changed. In other words, the positioning deflector 119 can determine the position of the image formed by the first slit 114a, etc. on the material 2.

The stage 120 supports the material 2, and is equipped with a moving mechanism for moving the material 2. The stage 120 is housed in a sample chamber maintained in a vacuum.

In the lithography system 100, the first slit 114a, forming deflector 115, forming lens 116, and second slit 114b can form the electron beam and control the cross-sectional shape, or shot shape, and the shot size of the electron beam irradiated onto the material 2. The time that the electron beam is irradiated to the material 2, i.e., the shot time, can be controlled by the blanker 112. The positioning deflector 119 can control the position of the electron beam irradiated on the material 2, i.e., the shot position. The lithography system 100 draws a pattern on the material 2 by irradiating the formed electron beam on the material 2 based on the pattern data.

The above discussion relates to a case of using an electron beam to draw on material 2, but charged particle beams other than electron beams, such as ion beams, may also be used to draw on the material 2.

Fig. 2 shows a schematic plan view of the stage 120.

Referring to Fig. 2, the lithography system 100 includes a first contact section 10 and a second contact section 20. The first contact section 10 and the second contact section 20 connect the material 2 to a reference potential. The reference potential is, for example, the reference potential of the lithography device 100. The reference potential may be a reference potential, a ground level (0 V), or a specific potential. By connecting the material 2 to the reference potential, charging of the material 2 due to electron beam irradiation can be prevented.

The stage 120 is provided with a plurality of clamps 122. The material 2 is secured to the stage 120 by the plurality of clamps 122. In the illustrated example, the material 2 is fixed to the stage 120 by three clamps 122. The material 2 supported on the stage 120 is fixed at a predetermined height.

The first contact section 10 and the second contact section 20 are disposed near to the clamp 122. In a plan view, the clamp 122 is disposed between the first contact section 10 and the second contact section 20. The first contact portion 10 and the second contact portion 20 are not limited.

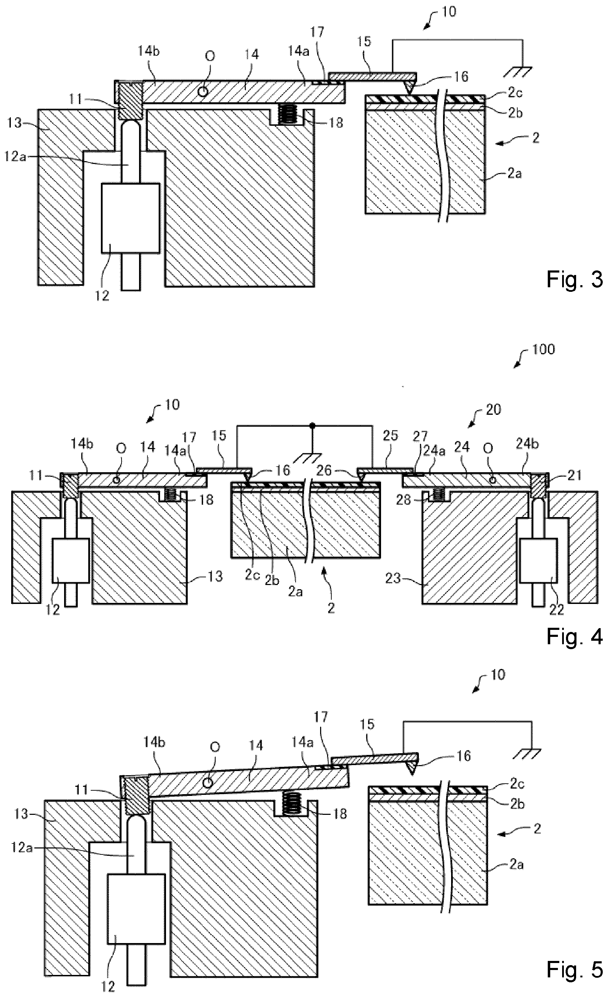

Fig. 3 schematically shows the first contact section 10.

Referring to Fig. 3, the first contact section 10 includes a height adjustment screw 11, a first actuator 12, a base 13, a first seesaw member 14, an elastic member 15, a first conduction pin 16, an insulating member 17, and an elastic member 18.

The first actuator 12 moves the first conduction pin 16. The first actuator 12 is a linear actuator that extends and retracts a rod 12a, e.g. as a device that converts the rotational motion of a motor into linear motion. The first actuator 12 may be a piezoelectric actuator powered by a piezoelectric element, but it is not limited and may be any actuator that can operate in a vacuum.
The first actuator 12 may be located outside the sample chamber maintained in a vacuum, and the first actuator 12 and the first seesaw member 14 may be connected via a link mechanism. This allows the first actuator 12 to move the first seesaw member 14 even though the first actuator 12 is not disposed within a vacuum.

The first actuator 12 moves the second end 14b of the first seesaw member 14 in the vertical direction by extending and retracting the rod 12a. The first actuator 12 moves the second end 14b via the height adjustment screw 11. The height adjustment screw 11 allows adjusting the relationship between the height of the rod 12a of the first actuator 12 and the height of the first conduction pin 16.

The base 13 is placed on the stage 120. By placing the first seesaw member 14 on the base 13, the height of the first conduction pin 16 and the material 2 can be aligned.

The first seesaw member 14 is located on the base 13. The first seesaw member 14 has a first end 14a and a second end 14b. The first seesaw member 14 has a fulcrum O between the first end 14a and the second end 14b. The first seesaw member 14 is configured for seesaw motion. When the first actuator 12 moves the second end 14b, the first seesaw member 14 rotates (seesaw motion) about the fulcrum O as the axis of rotation. As a result, the first conduction pin 16 connected to the first end 14a moves. For example, a bearing is used for the fulcrum O.

The elastic member 15 connects the first end 14a of the first seesaw member 14 to the first conduction pin 16. The elastic member 15 is, for example, a plate spring. The first end 14 a of the first seesaw member 14 is provided with an insulating member 17, and the elastic member 15 is connected to the insulating member 17. Therefore, the first conduction pin 16 and the elastic member 15 can be electrically insulated from the first seesaw member 14. The location of the insulating member 17 is not limited as long as the first conduction pin 16 can be connected to a reference potential.

The first continuity pin 16 connects the material 2 to a reference potential. The first continuity pin 16 is connected to the first end 14a of the first seesaw member 14. In the example shown, the first continuity pin 16 is connected to the first end 14a via the elastic member 15. The first conduction pin 16 is connected to a reference potential. The material of the first conduction pin 16 is, for example, diamond.

The elastic member 18 is connected between the first end 14a of the first seesaw member 14 and the fulcrum O. One end of the elastic member 18 is fixed to the base 13 and the other end of the elastic member 18 is fixed to the first seesaw member 14. The elastic member 18 is a compression spring. Therefore, the elastic member 18 applies a force to the first seesaw member 14 to push up the first end 14a. The elastic member 18 is not limited to an elastic body that generates a force similar to that of a compression spring, and may be a plate spring or the like.

Fig. 4, which is a cross-sectional view along line IV-IV of Fig. 2, schematically shows the first contact section 10 and the second contact section 20.

Referring to Fig. 4, the second contact section 20 has a height adjustment screw 21, a second actuator 22, a base 23, a second seesaw member 24, an elastic member 25, a second conduction pin 26, an insulating member 27 and an elastic member 28. The configuration of the second contact part 20 is similar to that of the first contact part 10 described above. in particular, the second seesaw member 24 has a first end 24a and a second end 24b, and has a fulcrum O between the first end 24a and the second end 24b. The second conduction pin 26 is connected to the first end 24a, and when the second actuator 22 moves the second end 24b, the second seesaw member 24 rotates and the conduction pin 26 moves.

In the above, the case in which the lithography device 100 has two contact sections is described, but in general the number of contact sections is not limited.

### 1.2. Operation

Figures 5, 6, and 7 illustrate the operation of the first contact section 10.

Referring to Fig. 5, when the first actuator 12 contracts the rod 12a, the elastic force of the elastic member 18 can position the first end 14a of the first seesaw member 14 above the second end 14b. This causes the first conduction pin 16 to not contact (disconnect) the material 2.

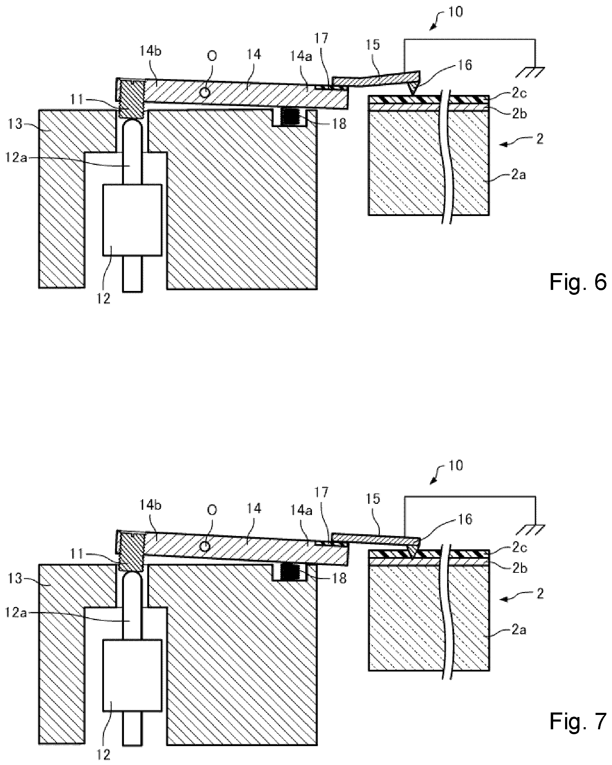

When the first actuator 12 extends the rod 12a from the state shown in Fig. 5, the first seesaw member 14 can rotate clockwise, moving the first end 14 a of the first seesaw member 14 below the second end 14b, as shown in Fig. 6. This allows the first conduction pin 16 to move downward, bringing the first conduction pin 16 into contact with the material 2.

Here, the load of the first conduction pin 16, i.e., the force pressing the first conduction pin 16 against the material 2, varies with the height of the first conduction pin 16. Specifically, the lower the height of the first conduction pin 16, the greater the force pressing the first conduction pin 16 against the material 2. Therefore, by controlling the height of the first conduction pin 16 with the first actuator 12, the force which presses the first conduction pin 16 against material 2 can be controlled.

When the first actuator 12 extends the rod 12a further from the state shown in Fig. 6, the first seesaw member 14 rotates further clockwise, as shown in Fig. 7. This results in a greater force pushing the first conduction pin 16 against the material 2 compared to the case shown in Fig. 6. As a result, the first conduction pin 16 breaks through the resist 2c and the first conduction pin 16 and the conductive layer 2b get into contact.

The material 2 includes, for example, a substrate 2a, a conductive layer 2b formed on the substrate 2a, and a resist 2c on the conductive layer 2b. The first conduction pin 16 is electrically connected to the conductive layer 2b by penetrating the insulating resist 2c. The first conduction pin 16 is connected to a reference potential. Therefore, the conductive layer 2b can be connected to the reference potential by contacting the first conduction pin 16 with the conductive layer 2b.

When the first actuator 12 contracts the rod 12a in the state shown in Fig. 6, the elastic force of the elastic member 18 causes the first seesaw member 14 to rotate counterclockwise, moving the first end 14a of the first seesaw member 14 above the second end 14b, as shown in Fig. 5. This allows the first conduction pin 16 to move upward and the first conduction pin 16 to move away from the material 2.

Thus, the height of the first conduction pin 16 can be changed by the first actuator 12, and by changing the height of the first conduction pin 16, the force of pressing the first conduction pin 16 against the material 2 can be controlled. Also, by changing the height of the first conduction pin 16, the first conduction pin 16 can be retracted to a position where it does not contact the material 2 supported by the stage 120.

In the above discussion, with the material 2 fixed to the stage 120, the first actuator 12 moves the first conduction pin 16 to bring the latter into contact with the conductive layer 2b. In contrast, before the material 2 is fixed to the stage 120, the height of the first conduction pin 16 may be set to the height shown in Fig. 7, where the first conduction pin 16 contacts the conductive layer 2b. This allows the material 2 to be fixed to the stage 120, thereby bringing the first conduction pin 16 into contact with the conductive layer 2b.

The operation of the second contact section 20 is the same as that of the first contact section 10 described above, *mutatis mutandis.*

### 1.3. Elastic member

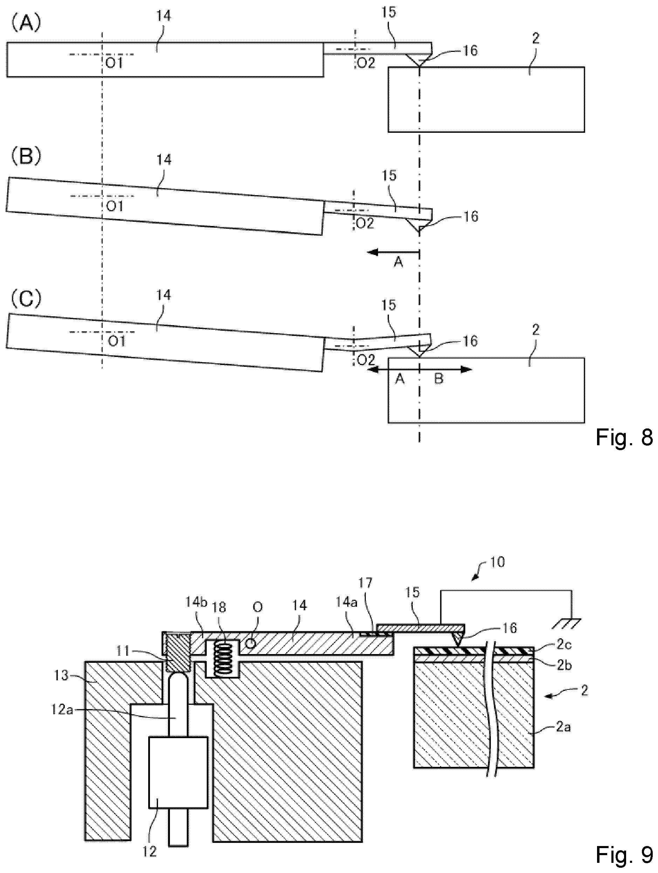

Fig. 8 illustrates the function of the elastic member 15. Figs. 8(A-C) illustrate the movement of the elastic member 15 when the first conduction pin 16 contacts the material 2.

Fig. 8(A) illustrates the first seesaw member 14 in a horizontal position. When the first seesaw member 14 is horizontal, the first conduction pin 16 is in contact with the surface of the material 2. The first seesaw member 14 rotates with the center of rotation at point O1, which is the position of the fulcrum O of the first seesaw member 14.

Fig. 8(B) shows the movement of the elastic member 15 in the absence of material 2, and Fig. 8(C) shows the movement of the elastic member 15 when the first conduction pin 16 contacts the material 2. In Figs. 8(B) and 8(C), the first seesaw member 14 is tilted by the same angle.

When the first seesaw member 14 is rotated clockwise from the horizontal state of the first seesaw member 14 shown in Fig. 8(A), the position of the tip of the first conduction pin 16 moves downward and in the first direction A, as shown in Fig. 8(B). The first direction A is perpendicular to the vertical direction.

When the first conduction pin 16 contacts the material 2, if the first seesaw member 14 is rotated clockwise from the horizontal state of the first seesaw member 14 shown in Fig. 8(A), the first conduction pin 16 contacts the material 2 and the elastic member 15 bends at point O2 by elastic deformation as shown in Fig. 8(C). The elastic member 15 bends at point O2 due to elastic deformation. The bending of the elastic member 15 tilts the first conduction pin 16, and the position of the tip of the first conduction pin 16 moves in the second direction B.

On the surface of material 2, the first direction A, which is the direction of movement of the tip of the first conduction pin 16 due to rotation of the first seesaw member 14, and the second direction B, which is the direction of movement of the first conduction pin 16 due to elastic deformation of the elastic member 15, are opposite directions. Therefore, the amount of horizontal movement of the tip of the first conduction pin 16 on the surface of material 2 can be reduced. Therefore, the scratches on the surface of the material 2 formed by the contact of the first conduction pin 16 with the material 2 can be reduced and the generation of dust can be reduced.

By adjusting the relationship between the position of point O1, the position of point O2, and the position of the tip of the first conduction pin 16, the amount of movement of the tip of the first conduction pin 16 due to rotation of the first seesaw member 14 and the amount of movement of the first conduction pin 16 due to elastic deformation of the elastic member 15 can be equal. As a result, on the surface of material 2, the movement of the tip of the first conduction pin 16 due to rotation of the first seesaw member 14 can be canceled by the movement of the first conduction pin 16 due to elastic deformation of the elastic member 15. Therefore, on the surface of material 2, the horizontal movement of the first conduction pin 16 can be extremely small. Therefore, the scratches on the surface of material 2 formed by the first conduction pin 16 contacting material 2 are reduced, and dust can be further reduced.

Referring to Fig. 8(A), it is desirable that first conduction pin 16 is in contact with the material 2 when the first seesaw member 14 is horizontal. When the first seesaw member 14 is rotated by an angle θ while the first seesaw member 14 is horizontal, the amount of horizontal movement of the position of the tip of the first conduction pin 16 is smaller than when the first seesaw member 14 is rotated by an angle θ while the first seesaw member 14 is inclined appreciably. Therefore, by having the first conduction pin 16 contact the material 2 while the first seesaw member 14 is horizontal, the scratches on the surface of the material 2 formed by the first conduction pin 16 contacting the material 2 can be smaller than when the first conduction pin 16 contacts the material 2 while the first seesaw member 14 is inclined at a high angle.

In the above, the operation of the elastic member 15 shown in Fig. 3 was explained, and the operation of the elastic member 25 shown in Fig. 4 is similar, *mutatis mutandis.*

### 1.4. Effect

The lithography system 100 includes a stage 120 that supports the material 2, a first conduction pin 16 for connecting the material 2 to a reference potential, and a first actuator 12 for moving the first conduction pin 16. Therefore, the lithography system 100 can move the first conduction pin 16 with the first actuator 12. Here, the force to push the first conduction pin 16 against the material 2 is greater the lower the height of the first conduction pin 16 is. Therefore, in the lithography system 100, the force to push the first conduction pin 16 against the material 2 can be variable.

For example, if the resist 2c of material 2 is thick, the force to press the first conduction pin 16 against the material 2 can be increased to ensure that the first conduction pin 16 contacts the conductive layer 2b. If the resist 2c of material 2 is thin, the force to press the first conduction pin 16 against the material 2 can be reduced to keep the first conduction pin 16 in contact with the conductive layer 2b, while reducing the generation of dust.

In the lithography system 100, the first actuator 12 moves the first conduction pin 16 between a position where the first conduction pin 16 contacts the material 2 supported on the stage 120 and a position where the first conduction pin 16 does not contact the material 2 supported on the stage 120. Therefore, the lithography system 100, when material 2 is not connected to the reference potential, the first conduction pin 16 can be placed in a position where the first conduction pin 16 does not contact material 2 (disconnect). This reduces the generation of dust.

In the lithography system 100, the first conductive pin 16 is connected to the first end 14a of the first seesaw member 14, and the second end 14b of the first seesaw member 14 is moved by the first actuator 12, which causes the first seesaw member 14 to rotate and the first conductive pin 16 to move. Therefore, in the lithography system 100, the linear motion of the first actuator 12 is converted into rotational motion, so as to move the first conduction pin 16.

The lithography system 100 includes an elastic member 15 connecting the first end 14a and the first conduction pin 16, and when the first conduction pin 16 contacts the material 2 by the first actuator 12 rotating the first seesaw member 14, the elastic member 15 is bent by elastic deformation. Therefore, in the lithography system 100, the scratches on the surface of the material 2 formed by the first conduction pin 16 contacting the material 2 can be reduced, and the generation of dust can be reduced.

### 1.5. Variants

### 1.5.1. First Modification

Fig. 9 schematically shows a variant of the first contact section 10.

In the first contact section 10 shown in Fig. 3 above, the elastic member 18 was connected between the first end 14 a of the first seesaw member 14 and the fulcrum O. Referring to Fig. 9, the elastic member 18 may be connected between the second end 14b of the first seesaw member 14 and the fulcrum O. One end of the elastic member 18 is fixed to the base 13 and the other end of the elastic member 18 is fixed to the first seesaw member 14. The elastic member 18 is a tensile spring. Therefore, the elastic member 18 applies a force to the first seesaw member 14 to push down the second end 14b.

The elastic member 18 is not limited to any elastic body that generates a force similar to that of a tension spring, and may be a plate spring or the like.

The operation of the first contact section 10 shown in Fig. 9 is the same as that of the first contact section shown in Figures 5, 6, and 7 above.
The operation of the first contact section is the same as that of the contact section 10, *mutatis mutandis.*

Although not shown in the figure, the second contact section 20 may have the same configuration as the first contact section 10 shown in Fig. 9.

### 1.5.2. Second Modification

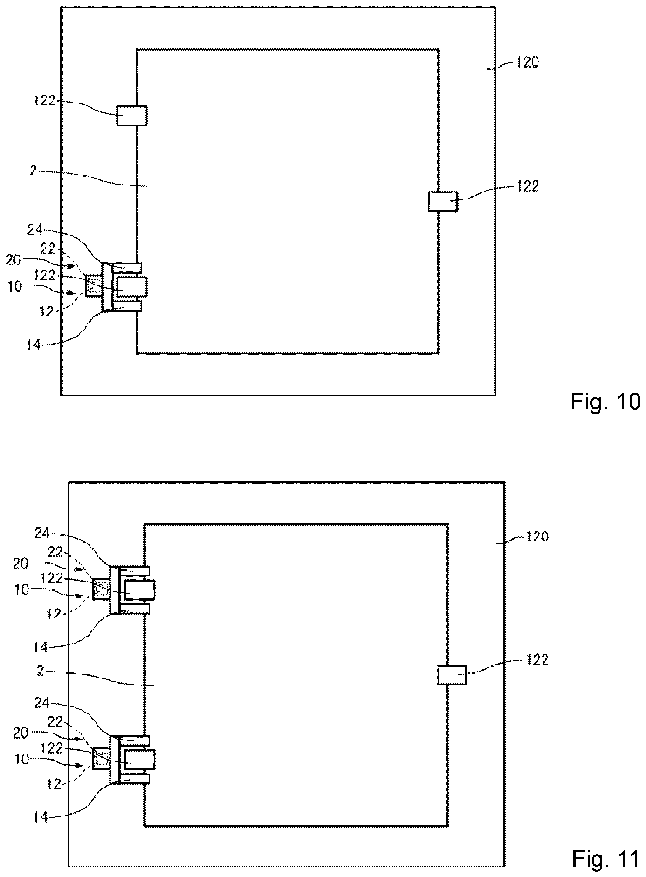

Fig. 10 schematically illustrates a variant of the first and second contact sections 10 and 20.

Referring to Fig. 10, the first seesaw member 14 and the second seesaw member 24 may be moved by a single actuator. In such a case the first actuator 12 may serve as the second actuator 22. For example, the lithography system 100 includes a link component, which connects the first seesaw member 14 and the second seesaw member 24. By moving the link component using a single actuator, the first seesaw member 14 and the second seesaw member 24 can be moved in a rotary motion. In this way, the actuator can be shared in the first contact section 10 and the second contact section 20.

In the lithography system 100 for the second variant, the first seesaw member 14 and the second seesaw member 24 are moved in a rotary motion with a single actuator, thus reducing the number of parts.

Fig. 11 schematically shows a variant of the first and second contact sections 10 and 20.

Referring to Fig. 11, a plurality of pairs of first and second contact sections 10 and 20 that share an actuator may be provided. In the example shown in Fig. 11, two pairs of the first and second contact sections 10 and 20 that share an actuator are provided.

### 2. Second embodiment

### 2.1. Lithography System

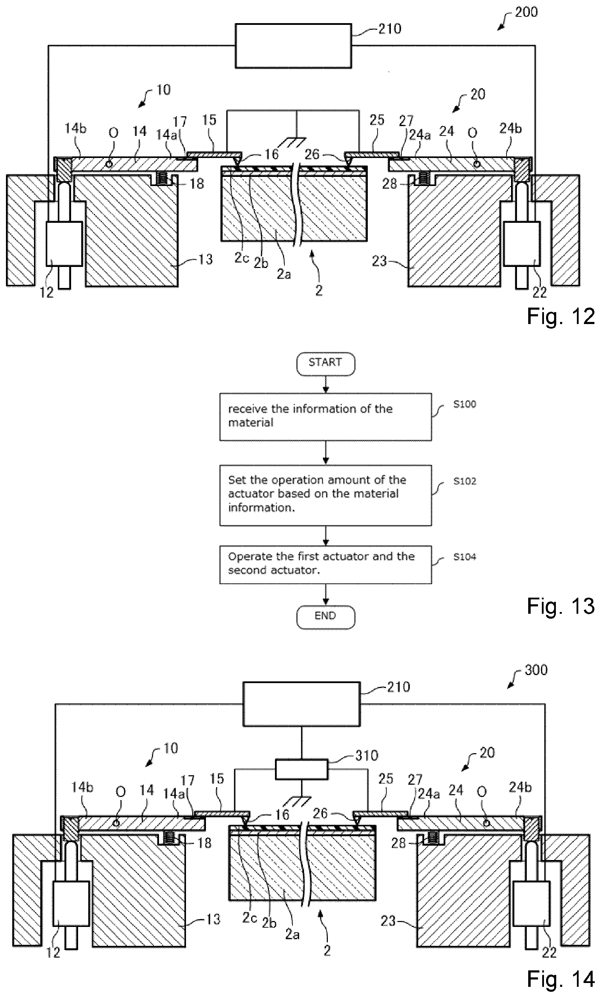

Next, the lithography system according to a second embodiment will be explained with reference to Fig. 12.

Fig. 12 shows the configuration of the lithography system 200 of the second embodiment. In the lithography system 200 of the second embodiment, members that have the same functions as the members of the lithography system 100 of the first embodiment will be marked with the same symbols, and their detailed descriptions will be omitted here.

Referring to Fig. 12, the lithography system 200 differs from the lithography system 100 shown in Fig. 4 above in that it includes a control unit 210 that controls the first and second actuators 12, 22.

Control unit 210 controls the first and second actuators 12, 22. The control unit 210 includes, for example, a processor such as a CPU (Central Processing Unit) and a memory device (memory) such as RAM (Random Access Memory) and ROM (Read Only Memory). The memory device stores programs and data for performing various controls. The functions of the control unit 210 can be realized by executing the program in a processor. The control unit 210 may be realized by a general-purpose circuit such as a microcontroller or microprocessor that operates according to a program, for example, or by a dedicated circuit such as an application specific integrated circuit (ASIC).

### 2.1. Processing in the Control Unit

Control unit 210 controls the first actuator 12 and second actuator 22 based on the information of material 2. Fig. 13 is a flowchart showing an example of the process of connecting material 2 to the reference potential in control unit 210.

Control unit 210 accepts information on material 2 (step S100).

The information of material 2 is, for example, the film thickness of resist 2c. The information of material 2 may, for example, include information on the material of resist 2C. If material 2 has multiple layers, the material 2 information may include information on the layer structure of material 2.

The user inputs information on material 2, for example, by operating the graphical user interface (GUI) or by operating input devices such as a keyboard, mouse, buttons, or touch panel. The control unit 210 accepts the material 2 information input by the user.

Based on the information of material 2, the control unit 210 sets the amount of movement of the first actuator 12 and the amount of movement of the second actuator 22. (step S102).

The memory section of control unit 210 stores in advance a table or relational equation that relates the film thickness of resist 2c to the actuator operation amount. The control unit 210 determines the amount of actuator movement according to the film thickness of the resist 2c, using a table or relational formulas stored in the memory section.

A table or relational equations relating the material (hardness) of resist 2c and the actuator movement amount is stored in the memory section of control unit 210 in advance. The control unit 210 obtains the amount of actuator movement according to the material of resist 2c from the table or relational formulas stored in the memory section.

For example, if resist 2c is made of a hard material, the actuator movement amount is set so that the force to press the first conduction pin 16 against the material 2 is increased. If the resist 2c is made of a soft material, the actuator is set so that the force to press the first conduction pin 16 against the material 2 becomes small. The force to press the first conduction pin 16 against the material 2 is set to be greater the lower the height of the conduction pin.

If the operation amount set based on the film thickness differs from the amount set based on the material, the control unit 210 adopts the larger operation amount.

Control unit 210 causes the first actuator 12 and second actuator 22 to operate by the set amount of movement (step S104). Consequently, the first actuator 12 is operated by the set movement amount. Similarly, the second actuator 22 is operated by the set amount of movement. This allows the first and second conduction pins 16 and 26 to press against the material 2 with appropriate force. As a result, the first and second conduction pins 16, 26 can contact the conductive layer 2b, connecting the material 2 to the reference potential.

The control unit 210 operates the first actuator 12 and the second actuator 22, and then terminates the process.

In the above, the case where the control unit 210 operates the first actuator 12 and the second actuator 22 based on the information of the material 2 was explained, but the control unit 210 may also control/operate the first actuator 12 and the second actuator 22 based on the information of the force to press the first conduction pin 16 against the material 2.

For example, the user enters information on the force required to penetrate resist 2c. The force required to penetrate resist 2c corresponds to the force to push the conduction pin against the material. The memory section of the control unit 210 stores a table or relational equation showing the relationship between the force of pressing the conduction pin against the material and the height of the conduction pin in advance. The control unit 210 determines the amount of actuator movement in response to the input force from the table or relational equation stored in the memory section. The control unit 210 operates the first and second actuators 12, 22 by the determined amount of movement. This allows the first and second conduction pins 16, 26 to press against the material 2 with the desired force.

### 2.3. Effect

The lithography system 200 includes a control unit 210 that controls the first actuator 12. The control unit 210 controls the first actuator 12 based on the information of the material 2. Therefore, the lithography system 200 can press the first conduction pin 16 against the material 2 with an appropriate force according to the film thickness of the resist 2c and the material of the resist 2c. Therefore, the lithography system 200 can reliably connect the material 2 to the reference potential and reduce the generation of dust.

In the lithography system 200, the information of material 2 is information about the film thickness of material 2. For example, the information on the film thickness of material 2 is information on the film thickness of resist 2c. Therefore, in the lithography device 200 can operate the first actuator 12 according to the film thickness of resist 2c, the first conduction pin 16 can be pressed against the material 2 with appropriate force according to the film thickness of resist 2c.

### 3. Third embodiment

### 3.1. Lithography System

Next, the lithography system according to a third embodiment will be explained with reference to Fig. 14.
The figure below shows the configuration of the lithography system 300 of the third embodiment. In the lithography system 300 pertaining to the third embodiment, members that have the same functions as the members of the lithography system 100 pertaining to the first embodiment and the lithography system 200 pertaining to the second embodiment are marked with the same symbols, and detailed descriptions thereof are omitted.

Referring to Fig. 14, the lithography system 300 includes a resistance measurement circuit 310.

The resistance measurement circuit 310 measures the resistance between the first conduction pin 16 and the second conduction pin 26. The resistance measurement circuit 310 is switchable between a state wherein it can measure the resistance between the first conduction pin 16 and the second conduction pin 26, and a state wherein the first conduction pin 16 and the second conduction pin 26 are connected to a reference potential. The resistance measurement circuit 310 outputs the measured resistance between the first conduction pin 16 and the second conduction pin 26.

### 3.2. Processing in the Control Unit

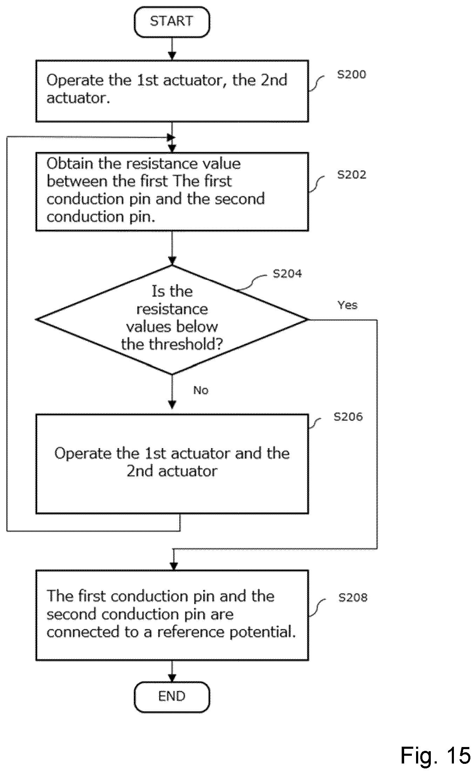

The control unit 210 is based on the resistance between the first conduction pin 16 and the second conduction pin 26. The first actuator 12 and the second actuator 22 are controlled. Fig. 15 is a flowchart showing an example of the process of connecting the material 2 to the reference potential in the control unit 21.

When the control unit 210 is instructed to start the process of connecting the material 2 to the reference potential, it operates the first and second actuators 12, 22 by the preset initial operating amount (step S200). This brings the first and second conduction pins 16, 26 into contact with the material 2.

Next, the control unit 210 obtains information on the resistance between the first conduction pin 16 and the second conduction pin 26 from the resistance measurement circuit 310 (step S202).

The resistance measurement circuit 310 is capable of measuring the resistance between the first conduction pin 16 and the second conduction pin 26. The resistance measurement circuit 310 outputs information on the resistance value. The resistance value information is sent to the control unit 210.

The control unit 210 determines whether the resistance between the first conduction pin 16 and the second conduction pin 26 is below the threshold value (step S204).

The threshold value is the resistance value when the first and second conduction pins 16, 26 are in secure contact with the conductive layer 2b. This allows the user to determine whether the first and second conduction pins 16 and 26 are in secure contact with the conductive layer 2b from the resistance value between the first and second conduction pins 16 and 26.

If the control unit 210 determines that the resistance value is not less than the threshold value (branch No in S204), i.e., the resistance value is greater than the threshold value, the first and second actuators 22 are operated (step S206). Specifically, the control unit 210 operates the first actuator 12 and the second actuator 22 by a preset amount of movement. As a result, the height of the first conductive pin 16 is lowered by the amount of movement of the first actuator 12, and the force pressing the first conductive pin 16 against the material 2 is increased. Similarly, the height of the second conductive pin 26 is lowered by the amount of movement of the second actuator 22, and the force of the second conductive pin 26 against the material 2 is increased.

After the control unit 210 operates the first actuator 12 and the second actuator 22 (after process S206), it returns to process step S202, in order to check the first and second conduction pins 16, 26 using the resistance measurement circuit 310 (step S202). The control unit 210 determines whether the resistance between the first conduction pin 16 and the second conduction pin 26 is below the threshold value (step S 204), and if it is determined that the resistance value is not less than the threshold value (No in step S204), the first and second actuators 12, 22 are operated (step S206).

Thus, the control unit 210 repeats the process step S202 of obtaining information on the resistance value, the process step S204 of determining whether the resistance value is below the threshold value, and the process step S206 of operating the first actuator 12 and the second actuator 22, until the resistance is determined to be below the threshold value.

If the control unit 210 determines that the resistance value is below the threshold value (branch Yes in S206), it connects the first conduction pin 16 and the second conduction pin 26 to the reference potential (step S208).

The control unit 210 switches the resistance measurement circuit 310 from a state in which the resistance between the first conduction pin 16 and the second conduction pin 26 can be measured to a state in which the first conduction pin 16 and the second conduction pin 26 are connected to a reference potential. This allows the material 2 to be connected to the reference potential. Since the resistance between the first and second continuity pins 16 and 26 is below the threshold value, material 2 can be safely connected to the reference potential. After the control unit 210 connects the first conduction pin 16 and the second conduction pin 26 to the reference potential, the process is terminated.

### 3.3. Effects

In the lithography system 300, the control unit 210 controls the first and second actuators 12, 22 based on the resistance between the first and second conduction pins 16, 26. Therefore, the lithography system 300 can reliably connect the material 2 to the reference potential. Furthermore, since the force to press the first and second conduction pins 16, 26 against the material 2 can be gradually increased, the generation of dust can be reduced.

In the lithography system 300, the control unit 210 repeats the process of determining whether the resistance value between the first conduction pin 16 and the second conduction pin 26 is below the threshold value and the process of operating the first actuator 12 and the second actuator 22 when it is determined that said resistance value is not below the threshold value, until it is determined that the resistance value is less than or equal to the threshold value. Consequently, the lithography system 300 can reliably connect the material 2 to the reference potential and reduce the generation of dust.

### 4. Fourth embodiment

### 4.1. Lithography System

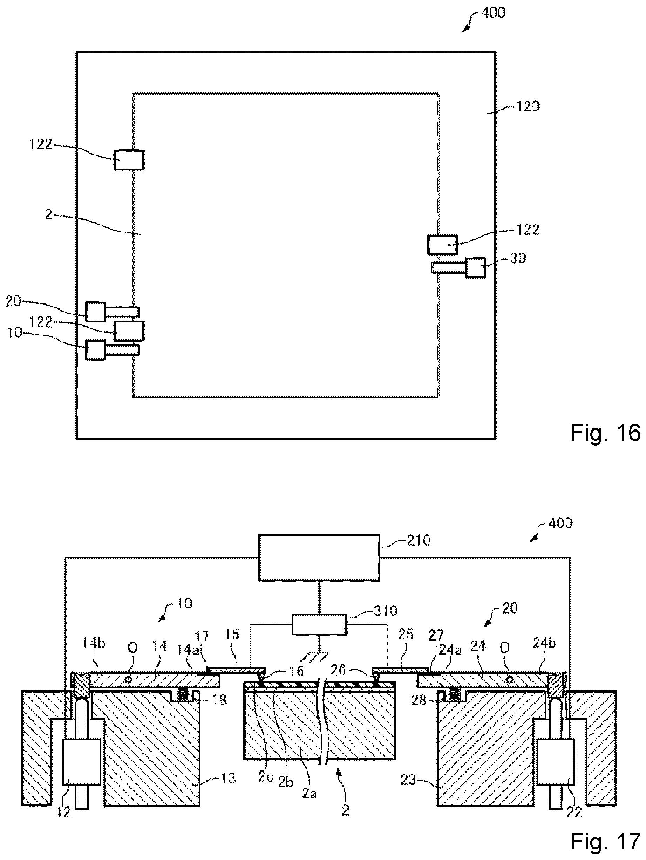

Referring to Figures 16-19, the lithography system according to a fourth embodiment will be explained.

Fig. 16 shows the configuration of the lithography system 400 of the fourth embodiment. In the lithography system 400 pertaining to the fourth embodiment, members having the same functions as the members of the lithography system 100 pertaining to the first embodiment, the lithography system 200 pertaining to the second embodiment, and the lithography system 300 pertaining to the third embodiment will be marked with the same symbols, and detailed descriptions thereof will be omitted.

The lithography system 400 includes a third contact section 30.

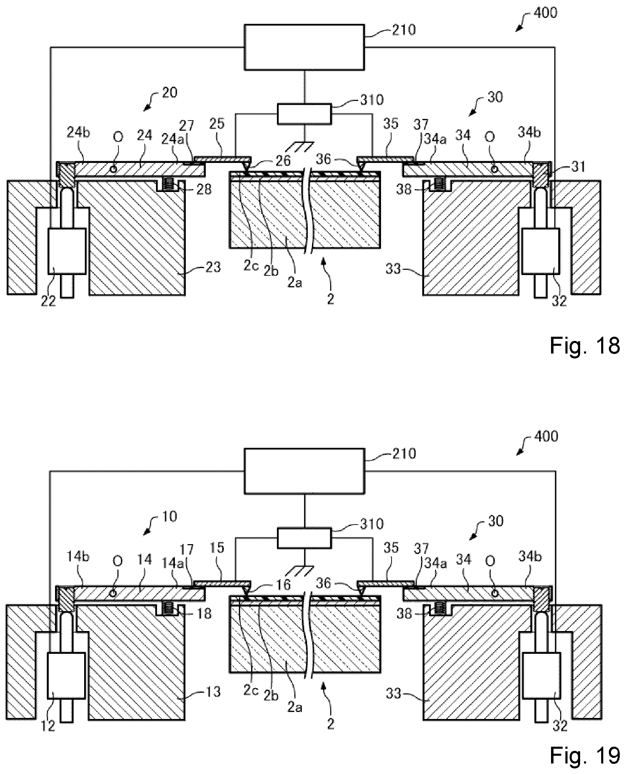

Fig. 17 schematically shows the first contact section 10 and the second contact section 20. Figure 18 schematically shows the second contact section 20 and the third contact section 30. Fig. 19 schematically shows the third contact section 30 and the first contact section 10.

The third contact section 30 includes a height adjustment screw 31, a third actuator 32, a base 33, a third seesaw member 34, an elastic member 35, a third conduction pin 36, an insulating member 37, and an elastic member 38 (Fig. 18). The configuration of the third contact section 30 is the same as that of the first contact section 10 and the second contact section 20 described above. In other words, the third seesaw member 34 has a first end 34a and a second end 34b, and has a fulcrum O between the first and second ends. The third conduction pin 36 is connected to the first end 34a, and when the third actuator 32 moves the second end 34b, this causes the third seesaw member 34 to rotate and the third conduction pin 36 to move.

The resistance measurement circuit 310 measures the resistance between the first conduction pin 16 and the second conduction pin 26, the resistance between the second conduction pin 26 and the third conduction pin 36, and the resistance between the third conduction pin 36 and the first conduction pin 16.

From the resistance between the first conduction pin 16 and the second conduction pin 26, the resistance between the second conduction pin 26 and the third conduction pin 36, and the resistance between the third conduction pin 36 and the first conduction pin 16, it is possible to identify which of the first, second, and third conduction pins 16, 26, 36 is not in contact with the conductive layer 2b.

For example, in case the first conduction pin 16 does not contact the conductive layer 2b, and the second and third conduction pins 26, 36 are in contact with the conductive layer 2b, the resistance between the first conduction pin 16 and the second conduction pin 26 and the resistance between the third conduction pin 36 and the first conduction pin 16 will be greater than the resistance between the second conduction pin 26 and the third conduction pin 36.

The resistance measurement circuit 310 is configured to measure the resistance between the first conduction pin 16 and the second conduction pin 26, the resistance between the second conduction pin 26 and the third conduction pin 36, and the resistance between the third conduction pin 36 and the first conduction pin 16; and it is configured to switch between a state in which the resistance between the first conduction pin 16, the second conduction pin 26, and the third conduction pin 36 can be measured, and a state in which the first conduction pin 16, the second conduction pin 26, and the third conduction pin 36 are connected to a reference potential.

### 4.2. Processing in the Control Unit

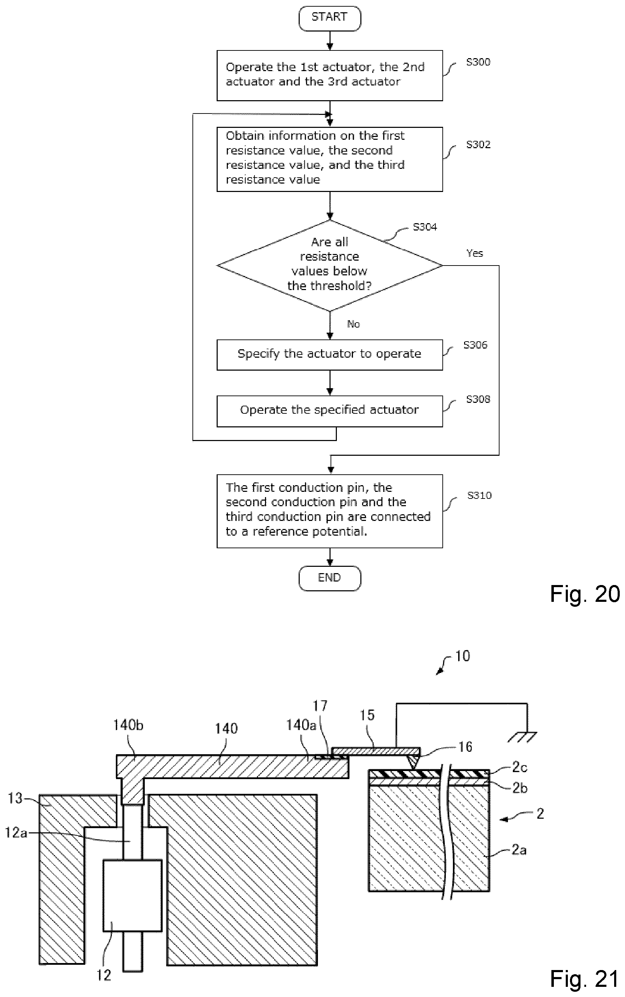

The control unit 210 is checking the resistance between the first conduction pin 16 and the second conduction pin 26, the second conduction pin 26 and the third conduction pin 36, and based on the resistance between the third conduction pin 36 and the first conduction pin 16, the first actuator 12, the second actuator 22, and the third actuator 32 are controlled. Fig. 20 is a flowchart showing an example of the process of connecting material 2 to the reference potential in control unit 210.

When the control unit 210 is instructed to start the process of connecting the material 2 to the reference potential, the control unit 210 will connect the first actuator 12, second actuator 22, and third actuator 32 by a pre-set initial operating amount (step S300). This brings the first conduction pin 16, second conduction pin 26, and third conduction pin 36 into contact with the material 2.

Next, the control unit 210 obtains from the resistance measurement circuit 310 information on the first resistance between the first conduction pin 16 and the second conduction pin 26, the second resistance between the second conduction pin 26 and the third conduction pin 36, and the third resistance between the third conduction pin 36 and the first conduction pin 16 (step S302)

Next, the control unit 210 determines whether the first, second, and third resistance values are below the threshold value (step S304). The threshold value is the resistance value when the two conducting pins are securely in contact with the conductive layer 2b.

If the control unit 210 determines that the first, second, and third resistance values are not all below the threshold value (No. in step S304), it identifies the actuator to be operated based on the first, second, and third resistance values (step S306).

For example, the control unit 210 determines whether each of the first, second, and third resistance values is less than or equal to the threshold value to identify the actuator to be operated. For example, if the first, second, and third resistance values are all greater than the threshold value, the first actuator 12, the second actuator 22, and the third actuator 32. In addition, for example, if the first resistance value is less than the threshold value and the second and third resistances are greater than the threshold value, the third actuator 32 is operated. In this way, the control unit 210 identifies the actuator to be operated.

Next, the control unit 210 operates the identified actuators (step S308). For example, if the identified actuator is the third actuator 32, the control unit 210 operates the third actuator 32 by the preset amount of movement. This lowers the height of the third conductive pin 36 by the amount of movement of the third actuator 32 and increases the force of the third conductive pin 36 against the material 2.

After the control unit 210 operates the identified actuators (after S308), the process returns to step S302, the obtaining information on the first, second, and third resistance values from the resistance measurement circuit 310 (step S302). The control unit 210 obtains the first, second, and third resistance to determine whether the resistance values are below the threshold (step S304) and all resistance values are not below the threshold (branch No in step S304), the actuators to be operated are identified (step S306) and the identified actuators are operated (step S308).

Thus, the control unit 210 repeats the process S302 of acquiring information on the first, second, and third resistance values, the process S304 of determining whether all resistance values are below the threshold value, the process S306 of identifying the actuators to be operated, and the process S308 of operating the identified actuators, until all S308 is repeated until all resistance values are determined to be less than or equal to the threshold value.

If the control unit 210 determines that all resistance values are below the threshold value (branch Yes in S304), the first conduction pin 16, the second conduction pin 26, and the third conduction pin 36 are connected to the reference potential (step S310). The control unit 210, after connecting the pins 16, 26, 36 to the reference potential, terminates the process.

In the process shown in Fig. 20 above, process S304 was performed to determine whether all resistance values are below the threshold value. In process S304, at least one of the first, second, and third resistance values may be determined to be below the threshold value. This allows at least one conduction pin to contact the conductive layer 2b.

In the above, the case where the lithography system 400 has three contact sections is described, but evidently the lithography system of the invention may also have more than three contact sections.

### 4.3. Effects

The lithography system 400 includes measuring the resistance between the first conduction pin 16 and the second conduction pin 26, the resistance between the second conduction pin 26 and the third conduction pin 36, and the resistance between the third conduction pin 36 and the first conduction pin 16, as well as a resistance measurement circuit 310 that measures the resistance between the first actuator 12, the second actuator 22, and the third actuator 32, and a control unit 210 that controls the first actuator 12, the second actuator 22, and the third actuator 32. The control unit 210 also controls the first actuator 12, the second actuator 22, and the third actuator 32 based on the resistance between the first conduction pin 16 and the second conduction pin 26, the resistance between the second conduction pin 26 and the third conduction pin 36, and the resistance between the third conduction pin 36 and the first conduction pin 16.

Thus, because the lithography system 400 has three conduction pins, the material 2 can be more reliably connected to the reference potential than, for example, when it has two conduction pins. In addition, because the lithography system 400 has three conduction pins, the conduction pins that are not in contact with the conductive layer 2b can be identified. As with the lithography system 300, the lithography system 400 can reliably connect the material 2 to the reference potential and reduce the generation of dust.

### 5. Fifth embodiment

Referring to Figures 21-23, the lithography system according to a fifth embodiment will be explained.

Fig. 21 schematically shows the first contact section 10 of the lithography system of the fifth embodiment. In the lithography system of the fifth embodiment, members having the same functions as those of the lithography system 100 of the first embodiment will be marked with the same symbols, and detailed descriptions thereof will be omitted.

In the first contact section 10 shown in Fig. 3, the first actuator 12 moved the first conductive pin 16 by linear motion and rotational motion of the first seesaw member 14. In contrast, in the first contact section 10 of the lithography system of the fifth embodiment, as shown in Fig. 21, the first actuator 12 directly moves the first conduction pin 16 without converting its linear motion into rotational motion.

The first contact section 10 includes a first actuator 12, a base 13, a support member 140, an elastic member 15, a first conduction pin 16, and an insulating member 17. (Fig. 21)

The support member 140 supports the first conduction pin 16. The support member 140 is a rod-shaped member extending horizontally. The support member 140 supports the first actuator 12 and the first conduction pin 16. The first end 140a of the support member 140 is connected to the first conduction pin 16 via the elastic member 15. A rod 12a is connected to the second end 140b of the support member 140. The second end 140b and the rod 12a are fixed.

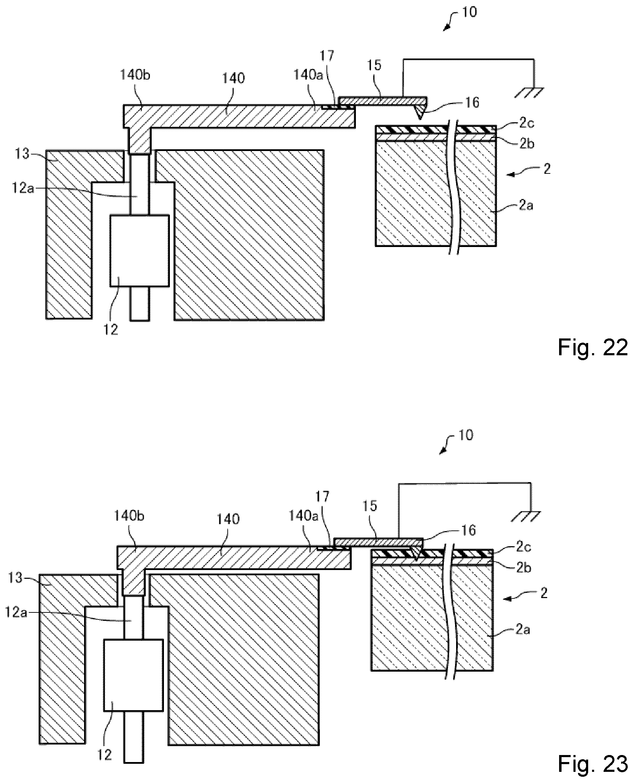

Figures 22 and 23 illustrate the operation of the first contact section 10.

Referring to Fig. 22, when the first actuator 12 extends the rod 12a, the support member 140 moves upward and the first conduction pin 16 moves upward. By moving the first conduction pin 16 upward, the first conduction pin 16 can be made to not contact (disconnect) the material 2. Referring to Fig. 23, by contracting the first actuator 12, the support member 140 moves downward and the first conduction pin 16 moves downward. By moving the first conduction pin 16 downward, the first conduction pin 16 can be pressed against the material 2.

The lithography system of the fifth embodiment can also achieve the same effects as the lithography system 100 of the first embodiment described above.

The above mentioned embodiments and variations are examples and are not limited to them. Furthermore, each embodiment and each variation can be combined as deemed suitable by the skilled person.

The present invention is not limited to the embodiments described above, and various further variations are possible. For example, the present invention includes configurations that are substantially identical to the configurations described in the embodiments. A substantially identical configuration is, for example, a configuration that is identical in function, method, and result, or a configuration that is identical in purpose and effect. The invention also includes configurations in which non-essential portions of the configurations described in the embodiments are replaced. The present invention also includes configurations that have the same action effect or can achieve the same purpose as the configuration described in the embodiment. The present invention also includes a configuration in which a known technology is added to the configuration described in the embodiments.

### Reference Numerals

- 2 :: material / substrate,
- 2a :: substrate,
- 2b :: conductive layer,
- 2c :: resist,
- 10 :: first contact area,
- 11 :: height adjustment screw,
- 12 :: first actuator,
- 12a :: rod,
- 13 :: base,
- 14 :: first seesaw member,
- 14a :: first end,
- 14b :: second end,
- 15 :: elastic member,
- 16 :: first conduction pin,
- 17 :: insulating member,
- 18 :: elastic member,
- 20 :: second contact part,
- 21 :: height adjustment screw,
- 22 :: second actuator,
- 23 :: base,
- 24 :: second seesaw member,
- 24a :: first end,
- 24b :: second end,
- 25 :: elastic member,
- 26 :: second conduction pin,
- 27 :: insulating member,
- 28 :: elastic member,
- 30 :: third contact part,
- 31 :: height adjustment screw,
- 32 :: third actuator,
- 33 :: base,
- 34 :: third seesaw member,
- 34a :: first end,
- 34b :: second end,
- 35 :: elastic member,
- 36 :: third conduction pin,
- 37 :: insulating member,
- 38 :: elastic member,
- 100 :: lithography system,
- 110:: electron optical system,
- 111 :: electron gun,
- 112:: blanker,
- 113 :: irradiation lens,
- 114a :: first slit,
- 114b :: second slit,
- 115 :: forming deflector,
- 116 :: forming lens,
- 117 :: reduction lens,
- 118 :: objective lens,
- 119 :: positioning deflector,
- 120:: stage,
- 122:: clamp,
- 140 :: support member,
- 140a :: first end,
- 140b :: second end,
- 200 :: lithography system,
- 210 :: control unit,
- 300 :: lithography system,
- 310 :: resistance measurement circuit,
- 400 :: lithography system,

## Claims

1. A lithography system for drawing patterns on a substrate by irradiating the substrate with a beam of charged particles, including
a stage for supporting the substrate,
a first conduction pin for connecting the substrate to a reference potential, and a first actuator for moving said first conduction pin.

2. The lithography system of claim 1, wherein the first actuator is configured to move the first conduction pin between a position where it contacts the substrate supported by the stage and a position where the first conduction pin does not contact the substrate supported by the stage.

3. The lithography system of claim 1 or 2, including a control unit for controlling the first actuator, wherein the control unit is configured to control the first actuator based on material information of the substrate and/or a resist film formed on the substrate.

4. The lithography system of claim 1 or 2, including a control unit for controlling the first actuator, wherein the control unit is configured to control the first actuator based on material information of a resist film formed on the substrate, including the film thickness of the resist film.

5. The lithography system of claim 1, further comprising
a second conduction pin for connecting the substrate to a reference potential and a second actuator for moving the second conduction pin,
a resistance measurement circuit configured to measure the resistance between the first and second conduction pins, and a
control unit to control the first and second actuators,
wherein the control unit is configured to control the first and second actuators based on the resistance value as measured by the resistance measurement circuit.

6. The lithography system of claim 5, wherein the control unit is configured to repeat the process of:
determining whether the resistance value is less than or equal to a predetermined threshold value, and
if the resistance value is not less than the threshold value, operating the first actuator and the second actuator,
until the resistance value is determined to be less than said threshold value.

7. The lithography system of any one of the preceding claims, further comprising a third conduction pin for connecting the substrate to a reference potential and a third actuator for moving the third conduction pin,
the resistance measurement circuit being configured to also measure the resistance between the second conduction pin and the third conduction pin, and the resistance between the third conduction pin and the first conduction pin,
the control unit being configured to also control the third actuator,
the control unit being further configured to control the first actuator, the second actuator, and the third actuator of the lithography system based on the measured values of the resistance between the first conduction pin and the second conduction pin, the resistance between the second conduction pin and the third conduction pin, and the resistance between the third conduction pin and the first conduction pin.

8. The lithography system of any one of the preceding claims, including a seesaw member having a first end and a second end and having a fulcrum between the first end and the second end, wherein the first conductive pin is connected to the first end, the first actuator is configured to move the second end so as to cause the seesaw member to rotate and the first conduction pin to move.

9. The lithography system of claim 8, including an elastic member connecting the first end and the first conduction pin, wherein said elastic member bends due to elastic deformation when the first actuator rotates the seesaw member and the first conduction pin contacts the substrate.
